Europäisches Patentamt

European Patent Office

Office européen des brevets

(19)

(11) Numéro de publication : **0 363 256 B1**

(12) **FASCICULE DE BREVET EUROPEEN**

(45) Date de publication du fascicule du brevet :
**22.04.92 Bulletin 92/17**

(21) Numéro de dépôt : **89402652.5**

(22) Date de dépôt : **27.09.89**

(51) Int. Cl.⁵ : **H05K 3/00,** B23K 26/00,
**H01L 21/74**

(54) **Procédé de réalisation de connexions électriques à travers un substrat.**

(30) Priorité : **29.09.88 FR 8812750**

(43) Date de publication de la demande :
**11.04.90 Bulletin 90/15**

(45) Mention de la délivrance du brevet :
**22.04.92 Bulletin 92/17**

(84) Etats contractants désignés :
**BE CH DE FR GB IT LI NL**

(56) Documents cités :
**EP-A- 0 164 564**
**US-A- 4 348 253**
**ELECTRONICS INTERNATIONAL, vol. 55, no.**
**11, 1982, page 48; J. LYMAN: "Laser drills**
**5-mil blind vias"**
**IBM TECHNICAL DISCLOSURE BULLETIN,**
**vol. 15, no. 2, juillet 1972, page 702, New York,**
**US; T. BKAER et al.: "Kerf oxide trench for**
**laser dicing"**

(73) Titulaire : **COMMISSARIAT A L'ENERGIE
ATOMIQUE Etablissement de Caractère
Scientifique Technique et Industriel
31/33, rue de la Fédération
F-75015 Paris (FR)**
Titulaire : **COMPAGNIE EUROPEENNE DE
COMPOSANTS ELECTRONIQUES LCC
50, rue Jean-Pierre Timbaud
F-92400 Courbevoie (FR)**

(72) Inventeur : **Deroux-Dauphin, Patrice
13, rue du Kif Tronchard
F-38120 Saint Egreve (FR)**
Inventeur : **Sibuet, Henri
4, rue Fétola - Le Fontanil
F-38120 Saint Egreve (FR)**
Inventeur : **Dupeux, Thierry
1 rue Auguste Renoir
F-38400 Saint Martin d'Heres (FR)**

(74) Mandataire : **Mongrédien, André et al
c/o BREVATOME 25, rue de Ponthieu
F-75008 Paris (FR)**

## Description

La présente invention a pour objet un procédé de réalisation de connexions électriques à travers un substrat.

Elle trouve une application , dans la réalisation de circuits intégrés ou de dispositifs destinés à l'enregistrement magnétique et plus généralement en microélectronique, en optoélectronique.

Pour s'en tenir à la réalisation de dispositifs d'enregistrement magnétique, le document de brevet européen EP-A-269 489 décrit une tête magnétique constituée par un substrat sur l'une des faces duquel se trouve une tête d'écriture et de lecture et sur l'autre face duquel se trouvent des circuits intégrés. Des "intraconnexions" sont alors établies entre la tête et les circuits à travers le substrat.

Pour réaliser ces intraconnexions, on perce le substrat de part en part et on utilise les trous obtenus pour établir une connexion électrique entre les deux faces du substrat.

De manière générale, le perçage d'un substrat peut s'obtenir par gravure chimique ou par gravure sèche. Mais ces deux techniques présentent des inconvénients : la première, étant isotrope, conduit à des vitesses de gravure latérale et verticale égales, ce qui ne permet pas d'obtenir des trous de faible diamètre et de grande profondeur ; la seconde, pose des problèmes d'évacuation des corps formés au-delà de 50 μm, ce qui réduit la vitesse de gravure ; mais même pour des profondeurs peu importantes, la vitesse de gravure reste faible (environ un demi-micron par minute), ce qui conduit à des temps de gravure de plusieurs heures.

Avec l'avènement du laser, est apparu un autre moyen de perçage de trous dans des substrats. La grande souplesse de réglage de la focalisation d'un faisceau laser, jointe à la possibilité de régler la durée et la puissance de l'impulsion laser, ont fait de cet appareil un moyen efficace de perçage de trous de faibles diamètres.

Une telle technique est décrite par exemple dans US-A 4,437,109 délivré le 13 Mars 1984 à T.R. ANTHONY et al pour "Silicon-on-Sapphire Body with Conductive Paths Therethrough".

De EP-A- 0 164 564 est connu un procédé de réalisation de trous borgnes dans un substrat tel que décrit dans le préambule de la revendication 1. Le substrat est revêtu d'un masque sur une première surface exposée au faisceau laser et d'une couche continue sur la surface opposée, tous deux en un matériau résistant au rayonnement.

L'utilisation d'un laser permet d'obtenir l'extrême précision requise dans le positionnement des trous, lorsqu'il s'agit d'interconnecter des circuits intégrés, précision qui doit être du même ordre que celle des machines réalisant les motifs de ces circuits. Une fois les trous obtenus, ils sont métallisés et des contacts sont établis sur chacune des faces du substrat.

Cependant, cette technique présente encore des inconvénients. En effet, les plaquettes de matériau semi-conducteur constituant le substrat doivent être manipulées pour des opérations supplémentaires de réalisation des divers circuits. Cette manipulation, conformément à une technique utilisée dans la plupart des équipements de microélectronique, s'effectue par aspiration. Or, lorsque ces plaquettes sont percées d'une multitude de trous, cette aspiration devient inopérante et il faut prévoir alors un autre moyen de manipulation.

Par ailleurs, le perçage par laser conduit à des projections de matériaux pulvérisés qui risquent de provoquer des courts-circuits ou diverses anomalies dans les circuits.

La présente invention a justement pour but de remédier à ces inconvénients. A cette fin, elle propose un procédé qui ne remet pas en cause la technique de manutention par aspiration des plaquettes percées et qui élimine les risques de projection.

Cet objectif est atteint grâce à l'invention par le moyen suivant. Avant de procéder à l'opération de perçage du substrat à l'aide d'un faisceau laser, on recouvre le substrat d'au moins une couche mince de matériau de coefficient d'absorption à la longueur d'onde du faisceau laser inférieur à celui du substrat. L'opération de perçage s'effectue alors de préférence par la face opposée à celle qui est recouverte par cette couche. Si le substrat se trouve encore perforé sous l'effet du faisceau laser, comme dans l'art antérieur, en revanche, la couche qui recouvre le substrat est traversée pratiquement sans dommage par le faisceau, de sorte que le trou obtenu finalement dans la plaquette est fermé par la couche. En d'autres termes, on obtient un trou borgne.

La plaquette n'étant pas percée de part en part, elle peut alors être manipulée aisément par aspiration. Par ailleurs, aucune projection de matériau ne se produit côté couche puisque celle-ci ferme l'orifice.

De façon plus précise, la présente invention a pour objet un procédé de réalisation de connexions électriques à travers un substrat, dans lequel on perce des trous dans le substrat au moyen d'un faisceau laser, et on établit des connexions électriques à travers le substrat en empruntant les trous ainsi percés, ce procédé étant caractérisé par le fait que, préalablement au perçage du substrat, on dépose sur une première face de celui-ci au moins une couche mince d'un matériau de coefficient d'absorption à la longueur d'onde dudit faisceau laser inférieur à celui du substrat, et l'on expose l'ensemble audit faisceau laser, les trous percés étant alors borgnes et n'affectant que le substrat.

Pour améliorer l'efficacité du procédé, plusieurs couches de matériau ayant des coefficients d'absorption différents et inférieurs à celui du substrat peuvent être utilisés.

On peut aussi utiliser une couche transparente au faisceau laser.

Les diverses connexions s'établissent ensuite selon des procédés connus, en remplissant partiellement ou totalement les trous borgnes par un matériau conducteur et en prenant ensuite les contacts appropriés avec les connexions réalisées sur les deux faces de la plaquette.

En ce qui concerne les propriétés électriques des matériaux utilisés, toutes les combinaisons sont possibles et notamment l'utilisation d'un substrat conducteur ou semi-conducteur avec une couche isolante, ou celle d'un substrat isolant avec une couche conductrice.

Lorsque la couche est conductrice, le fond du trou borgne constitue un plot conducteur qui se trouve être en contact avec la couche métallique déposée dans le trou borgne. La prise de contact est donc obtenue immédiatement.

Lorsque la couche est isolante, il faut, à un moment ou à un autre, percer le fond du trou, c'est-à-dire la couche. Ce perçage peut être effectué en fin de processus, par tout moyen connu, comme la gravure.

De toute façon, les caractéristiques de l'invention apparaîtront mieux à la lumière de la description qui suit, d'exemples de réalisation donnés à titre explicatif et nullement limitatif. Cette description se réfère à des dessins annexés sur lesquels :

– la figure 1 montre un substrat recouvert d'une couche de coefficient d'absorption inférieur à celui du substrat,

– la figure 2 illustre l'opération de perçage,

– les figures 3 à 6 illustrent quatre étapes de réalisation d'intraconnexions dans le cas où le substrat est semi-conducteur et la couche isolante,

– la figure 7 illustre une variante d'exécution correspondant au cas où le substrat est isolant et la couche conductrice.

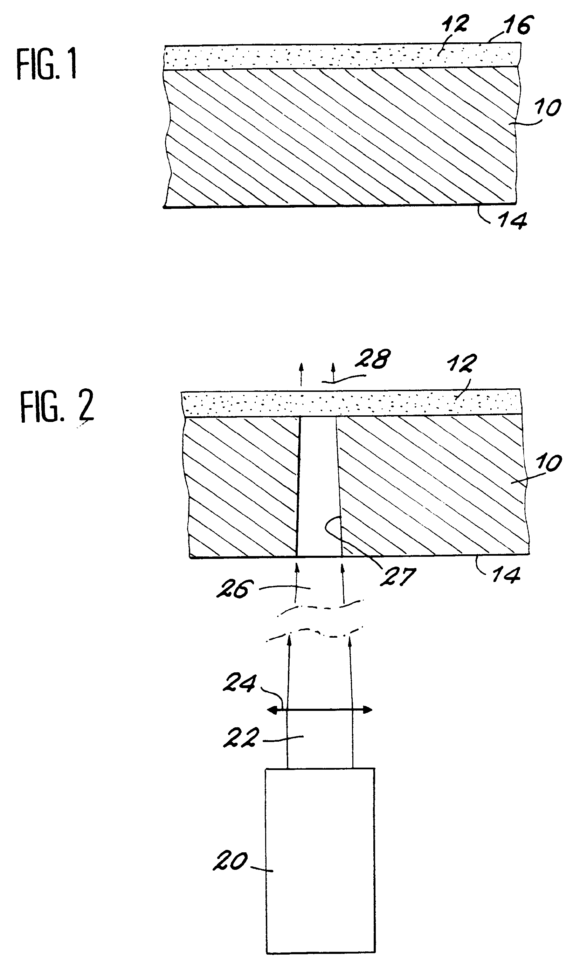

Sur la figure 1, on voit un substrat 10 sur lequel a été déposée une couche 12 d'un matériau ayant un coefficient d'absorption à la longueur d'onde du rayonnement du laser utilisé inférieur à celui du substrat. La plaquette ainsi obtenue possède une face "arrière" 14 et une face "avant" 16.

Le substrat 10 peut, par exemple, être en silicium et la couche 12 en silice ($SiO_2$). Dans ce cas, la couche de silice 12 peut être obtenue par croissance thermique en phase vapeur ou par dépôt par plasma ; mais tout autre procédé est possible.

En ce qui concerne les épaisseurs, on peut par exemple utiliser un substrat de 500 à 800 $\mu$m d'épaisseur et une couche de 0,5 à 4 $\mu$m. Il faut donc comprendre que les figures annexées ne sont pas à l'échelle pour plus de clarté.

La figure 2 illustre conformément à l'invention, la réalisation des trous borgnes. Un laser 20 émet un faisceau 22, lequel est focalisé par un moyen 24 et dirigé ensuite sur la face arrière 14 de la plaquette. Le laser est choisi de manière à ce que le matériau 10 soit absorbant à la longueur d'onde émise. Ce choix ne pose guère de problème à l'heure actuelle. Lorsque le substrat est semi-conducteur, un laser de puissance dont l'énergie des photons est supérieure à la largeur de bande interdite Eg du matériau peut convenir (le coefficient d'absorption étant une fonction de la largeur de la bande interdite). En particulier dans le cas du silicium (Eg = 1,1 eV) un laser Nd-YAG émettant à 1,06 $\mu$m (1,32 eV) convient parfaitement. Ce laser peut avantageusement fonctionner en mode déclenché ("Q-switched"). Le brevet américain cité plus haut donne des conditions d'utilisation de ce type de laser qui peuvent être reproduites dans la présente invention.

La couche 12 doit avoir un coefficient d'absorption inférieur à celui du silicium pour la longueur d'onde utilisée, ce qui est justement le cas de la silice, lorsque la longueur d'onde est de 1,06 $\mu$m.

Le coefficient d'absorption du silicium à la longueur d'onde 1,06 $\mu$m est d'environ $10^3$ cm$^{-1}$ et celui de la silice à cette longueur d'onde (1,06 $\mu$m) est inférieur à 1 cm$^{-1}$.

Le faisceau focalisé 26 frappant la face arrière 14, perce le substrat (il faut pour cela un train d'impulsions laser). Le trou obtenu 27 correspond sensiblement au diamètre du faisceau optique focalisé. En pratique le trou présente à l'entrée un diamètre de l'ordre de quelques dizaines de microns.

Le trou obtenu finalement est légèrement conique et peut présenter à l'extrémité fermée un diamètre de l'ordre d'une dizaine de microns.

Naturellement, avec des moyens de focalisation perfectionnés, ces diamètres peuvent être réduits.

Lorsque le faisceau atteint la couche 12, il est très peu absorbé et traverse cette couche sans la percer pour former un faisceau émergent 28.

Le perçage d'un tel trou borgne demande de 1 à 10 millisecondes.

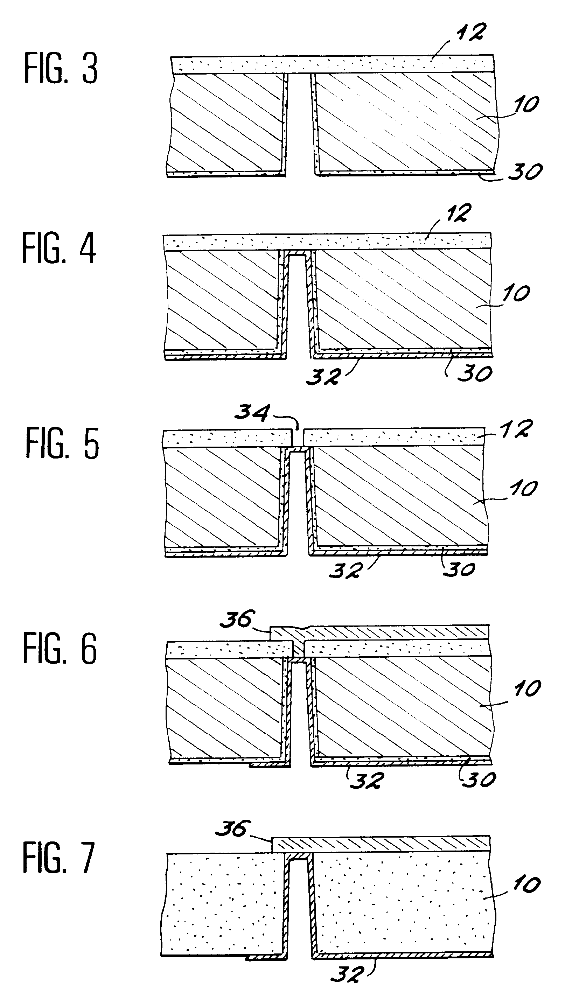

La plaquette percée de tels trous borgnes peut être ensuite traitée par des moyens traditionnels pour réaliser les intraconnexions proprement dites. Les figures 3 à 6 illustrent quelques étapes dans le cas nullement limitatif où le substrat 10 est supposé conducteur (en silicium par exemple) et la couche 12 isolante (en $SiO_2$ par exemple).

La figure 3 montre ainsi une couche 30 isolante déposée sur les parois et sur les bords du trou. On peut obtenir cette couche par oxydation thermique ou par dépôt LPCVD ("Low Pressure Chemical Vapor Deposition").

La figure 4 montre une couche conductrice 32 déposée sur les parois intérieures du trou préalablement revêtu de la couche 30 déjà mentionnée. La couche conductrice s'étend également sur les bords du trou. Cette couche peut être déposée en phase vapeur ou électrolytiquement.

On peut aussi remplir complètement le trou borgne de matériau conducteur (Cu, Fe,Ni...) par électrolyse ou par plaquage électrolytique.

Pour permettre la prise de contact avec la couche métallique 32, le fond du trou borgne est percé. L'ouverture 34 est pratiquée par masquage et gravure de la couche 12.

Les motifs des connexions peuvent alors être définis sur les deux faces de la plaquette avec prise de contact 36 sur la face avant et gravure appropriée de la couche 32 (Fig. 6).

Pour finir, la figure 7 illustre un autre mode de mise en oeuvre du procédé de l'invention dans le cas où le substrat 10 est isolant et la couche 12 conductrice. Dans ce cas, la couche isolante 30 des figures 3 à 6 est inutile et la couche conductrice 32 peut être déposée directement sur les parois du trou. Par ailleurs, la couche 12, étant conductrice, assure directement la prise de contact 36 avec la couche 32.

Des matériaux conducteurs et transparents qui conviennent dans cette application sont, par exemple : ITO (oxyde d'indium et d'étain), InSn, $SnO_2$, $In_2O_3SnO_2$ qui transmettent les rayonnements de longueur d'onde supérieure à 400 nm.

## Revendications

1. Procédé de réalisation de connexions électriques à travers un substrat (10), dans lequel on perce des trous dans le substrat (10) au moyen d'un faisceau laser (26), et on établit des connexions électriques à travers le substrat en empruntant les trous ainsi percés,
dans lequel, préalablement au perçage du substrat (10), on dépose sur une première face de celui-ci au moins une couche (12) d'un matériau et dans lequel on expose l'ensemble audit faisceau laser (26), les trous percés (27) étant alors borgnes et n'affectant que le substrat (10) caractérisé en ce que ladite couche de matériau est une couche mince d'un matériau ayant un coefficient d'absorption, à la longueur d'onde dudit faisceau laser (26) inférieur à celui du substrat.

2. Procédé selon la revendication 1, caractérisé par le fait que le substrat (10) est conducteur ou semi-conducteur et que la couche (12) est isolante.

3. Procédé selon la revendication 2, caractérisé par le fait que le substrat (10) est en silicium.

4. Procédé selon la revendication 2, caractérisé par le fait que la couche (12) est en silice.

5. Procédé selon la revendication 2, caractérisé par le fait qu'après l'opération de perçage des trous (27) on dépose sur les parois des trous une couche isolante (30).

6. Procédé selon la revendication 1, caractérisé par le fait que le substrat (10) est isolant et la couche (12) conductrice.

7. Procédé selon la revendication 6, caractérisé par le fait que la couche conductrice (12) est un matériau pris dans le groupe consistant en ITO, InSn, $SnO_2$, $In_2O_3SnO_2$.

8. Procédé selon la revendication 6, caractérisé par le fait que la couche conductrice (12) est gravée et sert de prise de contact (36).

9. Procédé selon l'une quelconque des revendications 5 ou 6, caractérisé en ce qu'on dépose dans au moins une partie des trous un matériau conducteur (32).

10. Procédé selon la revendication 8, caractérisé en ce que la couche étant isolante, celle-ci est gravée de part en part en regard des trous et en ce que l'on réalise des prises de contact sur cette couche.

## Patentansprüche

1. Verfahren zur Herstellung von elektrischen Verbindungen durch ein Substrat (10), bei welchem man mittels eines Laserstrahls (26) Löcher in das Substrat (10) brennt und man unter Benutzung der auf diese Weise eingebrannten Löcher elektrische Verbindungen durch das Substrat bildet, bei welchem man vor dem Durchbohren des Substrats (10) auf eine erste Seite desselben wenigstens eine Schicht (12) aus einem Material aufbringt und bei welchem man das Ganze besagtem Laserstrahl (26) aussetzt, wobei dann die eingebrannten Löcher (27) blind sind und nur auf das Substrat (10) eingewirkt wird, dadurch gekennzeichnet, daß die besagte Materialschicht eine dünne Schicht aus einem Material ist, welches einen niedrigeren Absorptionskoeffizienten bei der Wellenlänge des besagten Laserstrahls (26) als derjenige des Substrats besitzt.

2. Verfahren gemäß Anspruch 1, dadurch gekennzeichnet, daß das Substrat (10) leitend oder halbleitend ist und daß die Schicht (12) isolierend ist.

3. Verfahren gemäß Anspruch 2, dadurch gekennzeichnet, daß das Substrat (10) aus Silizium ist.

4. Verfahren gemäß Anspruch 2, dadurch gekennzeichnet, daß die Schicht (12) aus Siliziumoxid ist.

5. Verfahren gemäß Anspruch 2, dadurch gekennzeichnet, daß man nach dem Schritt des Einbrennens der Löcher (27) eine Isolierschicht (30) auf die Wandungen der Löcher aufbringt.

6. Verfahren gemäß Anspruch 1, dadurch gekennzeichnet, daß das Substrat (10) isolierend und die Schicht (12) leitend ist.

7. Verfahren gemäß Anspruch 6, dadurch gekennzeichnet, daß die leitende Schicht (12) ein aus der aus ITO, InSn, $SnO_2$, $In_2O_3SnO_2$ bestehenden Gruppe gewähltes Material ist.

8. Verfahren gemäß Anspruch 6, dadurch gekennzeichnet, daß die leitende Schicht (12) geätzt ist und als Kontaktstelle (36) dient.

10. Verfahren gemäß einem der Ansprüche 5 oder 6, dadurch gekennzeichnet, daß man wenigstens auf einen Teil der Löcher ein leitendes Material (32) aufbringt.

10. Verfahren gemäß Anspruch 8, dadurch gekennzeichnet, daß, wenn die Schicht isolierend ist, diese auf die Löcher hin völlig durchgeätzt ist und daß man auf dieser Schicht Kontaktstellen schafft.

**Claims**

1. Process for the production of electrical connections through a substrate (10), in which holes are made in the substrate (10) by using a laser beam (26) and electrical connections are produced through the substrate by following the thus made holes, wherein, prior to the perforation of the substrate (10), on a first face thereof is deposited at least one thin layer (12) of a material and wherein exposure takes place to the said laser beam (26), the holes (27) made then being blind and only affecting the substrate (10), characterized in that said material layer and a thin layer of a material having an absorption coefficient at the wavelength of said laser beam (26) lower than that of the substrate.

2. Process according to claim 1, characterized in that substrate (10) is conducting or semiconducting and layer (12) insulating.

3. Process according to claim 2, characterized in that substrate (10) is of silicon.

4. Process according to claim 2, characterized in that layer (12) is of silica.

5. Process according to claim 2, characterized in that following the operation of making the holes (27), an insulating layer (30) is deposited on the walls of the holes.

6. Process according to claim 1, characterized in that substrate (10) is insulating and layer (12) conducting.

7. Process according to claim 6, characterized in that the conducting layer (12) is of a material chosen from within the group consisting of ITO, InSn, $SnO_2$, and $In_2O_3SnO_2$.

8. Process according to claim 6, characterized in that the conducting layer (12) is etched and serves as a contact means (36).

9. Process according to either of the claims 5 and 6, characterized in that a conductive material (32) is deposited in at least part of the holes.

10. Process according to claim 8, characterized in that as the layer is insulating, it is etched right through facing the holes and in that contacts are produced on said layer.

FIG. 1

FIG. 2

FIG. 3

FIG. 4

FIG. 5

FIG. 6

FIG. 7